Europäisches Patentamt

European Patent Office

Office européen des brevets

(19)

(11) Publication number: **0 006 445**
**B1**

(12) **EUROPEAN PATENT SPECIFICATION**

(45) Date of publication of patent specification: **23.12.81**

(51) Int. Cl.³: **H 01 L 23/34**

(21) Application number: **79101565.4**

(22) Date of filing: **22.05.79**

(54) Methods of fabricating electrical apparatus comprising one or more heat generating electrical components.

(30) Priority: **29.06.78 US 920904**

(43) Date of publication of application:
**09.01.80 Bulletin 80/1**

(45) Publication of the grant of the European patent:
**23.12.81 Bulletin 81/51**

(84) Designated Contracting States:
**DE FR GB**

(56) References cited:
**EP - A - 0 000 244**
**EP - A - 0 001 153**
**DE - C - 1 146 165**

**IBM TECHNICAL DISCLOSURE BULLETIN**
**New York, Vol. 20, Nr. 3, August 1977,**
**O.R. GUPTA,**
**"Adjustable cold plate chip cooling"**
***pages 1120 to 1121***

**IBM TECHNICAL DISCLOSURE BULLETIN**
**New York, Vol. 21, Nr. 6, November 1978,**
**R.C. CHU et al. "Solid encapsulated module"**
***pages 2435 to 2436***

(73) Proprietor: **International Business Machines Corporation**
**Armonk, N.Y. 10504 (US)**

(72) Inventor: **Chu, Richard Chao-Fan**
**4 Sun Lane**
**Poughkeepsie, New York 12601 (US)**
Inventor: **Hwang, Un-Pah**
**6 Simone Drive**
**Poughkeepsie, New York 12603 (US)**
Inventor: **Simons, Robert Edward**
**16 Shamrock Circle**
**Poughkeepsie, New York 12603 (US)**

(74) Representative: **Lewis, Alan J.**
**IBM United Kingdom Patent Operations Hursley Park**
**Winchester, Hants, SO21 2JN (GB)**

Courier Press, Leamington Spa, England.

## Method of fabricating electrical apparatus comprising one or more heat generating electrical components

The invention relates to methods of fabricating electrical apparatus comprising one or more heat generating electrical components, that is electrical apparatus comprising a heat generating electrical component or components, a heat sink and a heat transfer path for transferring heat from the or each component to the heat sink.

U.S. specification No. 3,993,123 shows an example of cooled electrical apparatus comprising one or more heat generating electrical components mounted on a substrate. A heat sink provided by a heat conductive cap is sealed to the substrate and encloses the heat generating components. The wall of the cap opposite the substrate contains elongated openings therein extending towards the heat generating components and on the same centres with respect thereto. A resilient member is located in each opening in the cap and acts against the inner end of the opening. A thermal conductive element or piston is comprised in the heat transfer path from the component to the heat sink and is located in the aligned opening. The piston is of a size to leave only a small peripheral gap between the peripheral opening wall and the associated thermal conductive element. Each resilient member urges its thermal conductive element or piston into heat conducting pressure contact with the aligned heat generating component. A thermal conductive inert gas is located within the cap filling the peripheral gaps and any spaces in the interfaces between the heat generating elements and the thermal conductive elements. The heat is removed from the cap by external heat removal means e.g. a heat sink.

The conduction cooling scheme of U.S. specification No. 3,993,123 normally keeps the electronic components to be cooled operating within their specified thermal limits. However, some difficulty has been experienced in forming a seal to contain the gas within the module which will last for the lifetime of the components or the apparatus in which the module is used. Further, the heat conductivity properties of the gas limit the rate at which heat can be transferred across the gaps associated with the heat transfer paths. In addition the surrounding gas has substantially no damping effect on vibratory or other movements of the thermal conductive element.

An article entitled "Design for providing thermal interface material between narrow thermal interface gaps" appearing on pages 2761—62 of the IBM Technical Disclosure Bulletin Vol 20 No. 7, December 1977, discloses another example of electrical apparatus comprising a module including one or more heat generating electrical components mounted on a substrate and from each of which heat is conducted by conduction via a thermally conductive piston element sliding in a cylinder in a conducting cap or cover forming part of a heat sink. The articles disclose forming a blind bore into the piston element from the component engaging end face, filling the closed inner end portion of the bore with a low-boiling-point liquid (e.g. fluorcarbon) and then filling the rest of the bore with a thermal compound. The purpose of this is stated to be that when the element is heated, the vapour pressure of the liquid, in conjunction with the decreased viscosity of the thermal compound, forces the compound out of the blind bore into the space between the element and the component. Such an arrangement is not wholly reliable since the vapour pressure is necessarily sensitive to the precise temperature attained and too low or too high a temperature can result in a defective interface. In addition the width of the interface gap, which is dependant on many factors, e.g. manufacturing tolerances, biasing spring rating, etc, determines the pressure needed to spread the thermal compound and the volume of compound needed to fill the interface gap volume. Thus, a narrow gap width requires a higher pressure (i.e. higher temperature) and less compound than a wider gap width and these factors cannot be accurately predicted. In some cases the small volume of thermal compound that can be introduced into the end portion of the blind bore can be insufficient to fill the interface gap. In addition the residual presence of the volatile liquid is undesirable. The article discloses a similar low-boiling-point liquid/thermal compound combination to introduce the compound into the inter-face gap between the piston element side wall and the wall of the cylinder from the closed inner end of the cylinder.

The present invention provides an improved method of fabricating electrical apparatus in that it avoids or overcomes difficulties previously experienced. In particular the present invention provides a method of fabricating an electrical apparatus that is practical and which can successfully be implemented on an industrial scale.

Accordingly the present invention provides a method of fabricating electrical apparatus comprising a heat generating electrical component from which heat is conducted to a heat sink by conduction from the component to a piston slidably fitting in a cylinder bore in a housing and urged outwardly of the bore into heat conducting contact with the component, from the piston to the housing and from the housing to the heat sink, said method being characterised by the provision of an annular groove around the peripheral surface of the piston together with a plurality of other grooves leading from the annular groove lengthwise along that surface, by disposing a ring of a solid heat conducting medium having a low melting point between the piston and the wall of the bore in the annular groove around the piston, and heating the apparatus to melt the medium and cause it to be drawn along the other grooves and at least partially fill the gap between the piston and the wall of the bore.

Preferably the method is further characterised by the provision of a passage extending lengthwise into the piston from an opening in the face of the piston contacting the component and by the disposition in the passage of a quantity of the solid medium such that during the heating the medium is introduced into gaps between the contacting surfaces of the piston and the component.

The invention will now be further described by reference to specific examples embodying the invention, which examples are illustrated in the accompanying drawings, in which:—

Fig. 1 is a vertical cross-sectional view through a first embodiment of the invention showing the interfaces filled with heat conductive solid material.

Fig. 2 is an enlarged cross-sectional view showing one of the pistons within a cylinder with the thermal conductive material contained in the piston, that is, before reflow.

Fig. 3 is an enlarged cross-sectional view of a single piston within the cylinder with the thermal conductive material reflowed into the interfaces.

Fig. 4 is an enlarged end view of one of the pistons.

Fig. 5 is an enlarged side view of one of the pistons before the thermal conductive material is added thereto.

Fig. 6 is an enlarged bottom view of one of the pistons showing grooves therein.

Fig. 7 is another embodiment showing a single chip air cooled module.

Fig. 8 is a graph of maximum allowable chip power vs. module power.

Fig. 9 is a plan view of the single chip air cooled module showing the square configuration of the cooling fins.

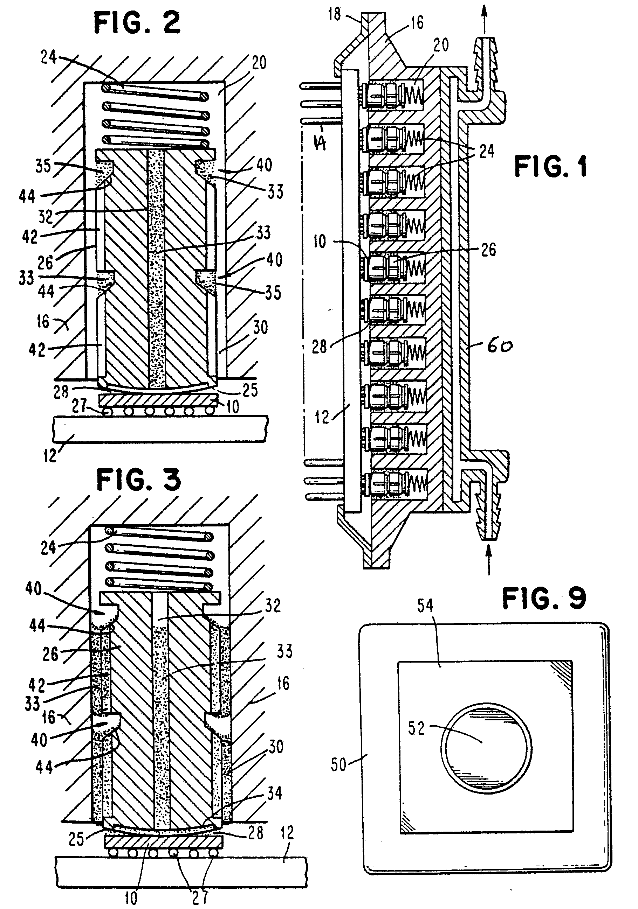

Referring to Fig. 1, there is shown a cross-sectional view of a first embodiment of the invention in electrical apparatus referred to as a conduction cooled module and capable of providing cooling of the solid state electronic chips or components to be cooled. As is well known, the chip consists of integrated circuits and devices which are densely packed on each chip. The power consumed in the circuits within the chip generates heat which must be removed from the chip. Since the various circuits have different power requirements, and since the integrated components thereon must be maintained within certain temperature ranges for reliable operation, the cooling must be of such character as to maintain the chip temperature within the required operating range.

The chips 10 are mounted on one side of a substrate 12, generally made of multi-layer ceramic, which has pins extending from the other side thereof. These connecting pins 14 provide for the plugging of the module into a board (not shown) which may very well carry auxiliary circuits, etc. A housing or cap 16 is attached to the substrate 12 by means of a flange 18 which extends from the periphery of the substrate 12 to the can 16. The cap 16 is made of a good heat conductive material such as copper or aluminium. The cap 16 is sufficiently thick to accommodate cylinder bores 20 therein. A spring means 24 is located in each bore 20 at the bottom thereof. The bores 20 within the cap 16 are accurately sized to receive a thermal conductive piston 26, one end of which abuts the spring member 24 and the other end of which abuts the face of the chip 10 forming a gap 28 therebetween. As can be seen in Figs. 2 and 3, piston 26 is dimensioned such that a small annular gap 30 exists between its circumference and the side walls of the bore 20 in the cap 16. The gap 30 is kept as small as possible but not so small as to frictionally impede the in and out movement of the piston 26. Thus, the spring force on piston 26 applies a predetermined pressure of the piston 26 against the chip 10 to provide a good thermal contact.

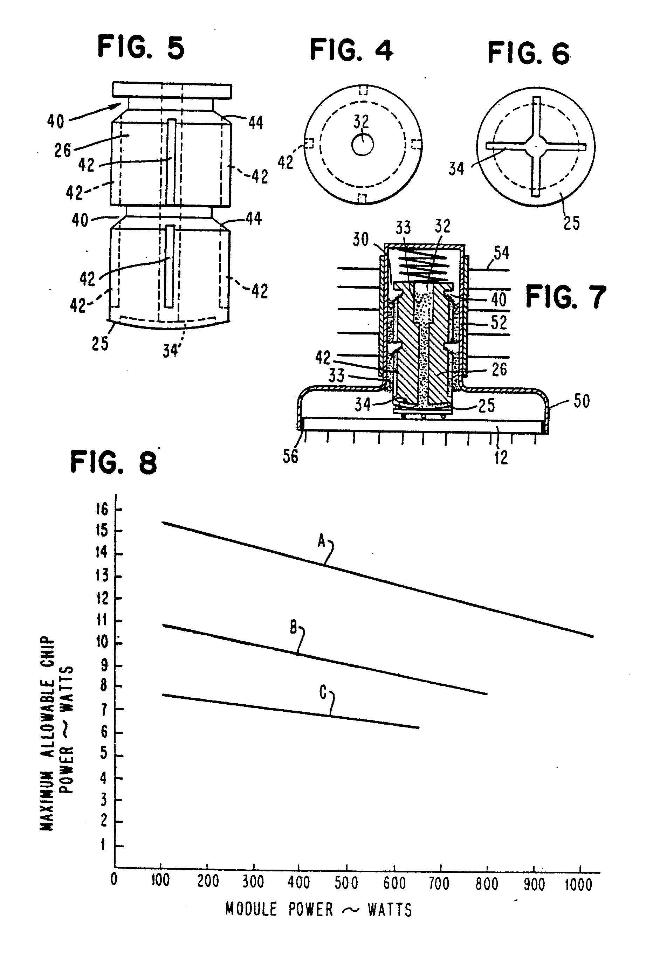

The piston 26 has a slightly convex or crowned end surface which contacts the chip 10 surface. This bottom surface 25 of the piston 26 is curved such that there will be surface contact between the bottom surface of the piston and the back surface of the chip 10 regardless of any chip tilt that may occur. As can be seen from Figs. 2 and 3, the chips 10 are mounted mainface down, that is facing toward the substrate 12, on solder balls 27. The solder ball 27 attachment of the chip 10 to the substrate 12 does not consistently provide a level chip. The piston 26 has a passage 32 extending axially and centrally through it from the top surface to the bottom surface thereof. Figs. 3 and 6 show grooves 34 extending radially from the opening at the end of the passage 32 to near the periphery of the end surface 25 of the piston 26. A low melting point thermal conductive material 33 such as wax is utilized to fill the passage 32 in the piston 26 before assembly. The wax 33 could be in the form of a solid dowel and mechanically slid into the passage 32 or it could be heated and allowed to flow into the passage 32. After assembly of the piston 26 into the module, the module is heated causing the wax to reflow. The grooves 34 provide a channel for the wax to travel along. The wax 33 will extend into the grooves 34 by a combination of the gravitational force on the wax in the passage 32 and capillary action. These grooves 34 are instrumental in getting the wax 33 distributed into the gap 28 between the surface 25 of the piston 26 and the back of the chip 10 by capillary action. It can be seen that the wax 33 must be of sufficiently low viscosity to flow along the grooves 34 and to spread by capillary action into the interface areas. The actual wax used was an elastic-type of wax called Ultraflex Amber Microwax manufactured by Mitchell Rand Corp. The melting point of the wax must be sufficiently high that it will remain solid after reflow when subjected to the chip heat. The melting point of the wax must be sufficiently low that the heat of reflow does not cause problems in the module, for example, it must be below the temperature of reflow of the solder balls connecting the chip 10 to the substrate 12. The reflow temperature utilized was approximately 80°C. The wax 33 during reflow within the module does not flow out of the gap 28 between the bottom face 25 of the piston 26 and the back of the chip 10 but is held therein by surface tension.

As can be best seen in Fig. 5, the piston 26 has circumferential grooves 40 around its periphery. The number of grooves 40 is a function of the length of the piston 26, the dimensions of the gap 30 between the cylinder housing 16 and the piston 26, the piston diameter and the depth of the circumferential groove 40. These circumferential grooves 40 are preloaded with a low melt point, good thermal conductive material such as wax 33 similar to the preloading of the passage 32 in the piston 26. The wax 33 is preloaded in the form of a solid ring 35 (see Fig. 2). The size of the ring 35 is predetermined and is dependant on the cross-sectional area of the gap 30 between the cylinder housing 16 and the piston 26 to be filled. Grooves or channels 42 extend from the circumferential grooves 40 to the next circumferential groove or in the case of the bottom circumferential groove, the channels 42 extend to a point near the end surface 25 of the piston 26. As was set forth in connection with the wax 33 loaded in the passage 32 of the piston 26, the wax 33 loaded in the circumferential grooves 40 is melted by applying heat after the piston 26 is located in the housing. It should be noted that the bottom side surface 44 of the circumferential grooves 40 extend downward to facilitate the flow of the wax from the circumferential grooves 40 into the gap 30 to be filled. Also, the channels 42 facilitate the flow of the wax 33 from the circumferential grooves 40 and aid in the distribution of the wax 33 throughout the gap 30. The flow of the wax 33 is accomplished by gravitational force as well as the spreading by capillary action. Fig. 2 shows the rings 35 of wax 33 located in the circumferential grooves 40 with the piston 26 assembled into the module but before the application of heat for reflow of the wax. Fig. 3 similarly shows the piston 26 assembled in the module but after the heat has been applied and the wax ring 35 reflowed into the gap 30 between the cylinder housing 16 and the piston 26 wall. The volume of wax contained in both the central opening 32 and the circumferential grooves 40 in the piston 26 is predetermined to be sufficient to fill the respective gaps.

It has been found that for an aluminum piston, optimum heat transfer can be obtained with a length of 15.2 mm and a diameter of 5.5 mm. The passage 32 through the piston 26 along the central axis thereof can be made in two stages for manufacturing ease, (see Fig. 7). The upper half of the passage is approximately 1 mm in diameter and the bottom half is approximately .5 mm in diameter. The circumferential grooves 40 were made approximately 1 mm wide whereas the three vertical channels 42 were made .5 mm square. The grooves 34 in the bottom surface 25 of the piston 26 were made approximately .13 mm wide and .13 mm deep. It was found that three or four such radial grooves 34 were sufficient to serve as feedlines for the molten wax 33 in order to fill the entire gap 28. The piston 26, after loading of the wax 33 therein and assembly into the module and after being heated in an oven to cause the reflow of the wax into the gaps 28 and 30 is allowed to cool, the wax 33 forms a relatively solid connection between the housing cylinder 16 wall and the piston 26 wall thereby providing a dampening effect to shock. In the helium filled gap type module of the prior art a shock or high inertia force often caused the piston to slam into the spring, causing the spring to compress and, correspondingly, force the piston back down against the chip with sufficient force to damage the fragile chip. As just mentioned, the solid wax 33 for the most part, prevents vibration and shock damage caused by the piston 26 being forced against the chip 10.

The wax 33 generally has a thermal conductivity which is twice that of helium. Therefore, the gap resistance between the chip 10 surface and the bottom surface 25 of the piston 26 is reduced as well as the thermal resistance between the peripheral wall of the piston 26 and the cylinder housing 16 wall. Other advantages of using wax are that the wax may be readily removed for rework, is compatible with the chip and module, has low cost, and simplifies the module sealing. The thermal conductivity of plain wax is about 0.27 watts/m°K and can be greatly increased with the addition of filler material. The wax can have zinc oxide powder mixed therein to enhance the thermal conductivity. A thermal conductivity six times greater than helium has been obtained, approximately 0.865 watts/m°K, using filler materials. Similarly, aluminium oxide powder can be utilized as a mix with the wax to increase the thermal conductivity thereof.

Referring to Fig. 8, there is shown a plot of the maximum allowable chip power in watts vs. the module power in watts using various materials within the module. This gives an indication of the cooling capability of the module and more particularly the improved performance obtained for various materials. For example, line A on the graph is a plot of the results obtained using a copper piston with the interfaces filled with a mixture of wax and a filler material such as zinc oxide powder. It can be seen that the maximum allowable chip power in a module consuming 100 watts is 15 1/2 watts. Plot B was obtained using a copper piston and plain wax in the interfaces. It can be seen that the maximum allowable chip power is 10.8 watts in a module consuming 100 watts. Similarly, plot C shows that an aluminum piston with plain wax in the interfaces in the module limits the maximum allowable chip power to 7.8 watts in a 100 watt module. Thus, it can be seen that there is considerable difference in the cooling capability using plain wax or filled wax in the interfaces and also considerable difference in the cooling capability between a copper and aluminum piston.

As can be seen from Figs. 1, 2 and 3 the heat transfer path is from the chip 10 to the bottom surface 25 of the piston 26 across the gap 28 therebetween and from the piston 26 to the cylinder housing 16 across the gap 30 between the piston 26 peripheral wall and the cylinder 16 wall. Thus, the module must be designed to obtain the required heat transfer rate to maintain the chip 10 within its required operating range. This is done through the selection of the material in the gaps and the material selected for the housing and the piston. The heat accumulated in the housing 16 from each of the pistons 26 is transferred to a cold plate 60 which is attached to the housing 16. The housing 16 surface is relatively flat so that the cold plate 60 can be attached thereto in good thermal conductive relation. The housing 16 can also serve as the wall of the cold plate 60. The cold plate 60 has a cooling liquid circulated therethrough which removes the heat transferred to the cold plate.

The module is not limited to the cold plate type of exterior heat removal. The outer surface of the housing 16 can have fins extending therefrom such that air can be forced thereacross to remove the heat.

It should be noted that the module must be oriented during the heating cycle such that the piston is essentially vertical so that the wax can run down the interface surfaces to be filled by gravitational force. However, once the cooling of the wax to its solid form takes place, the module can be operated independent of its orientation. Accordingly, it will work in a low gravity or zero gravity environment such as in space or on the lunar surface.

Since the stringent sealing requirements necessary for containing the helium have been relaxed by replacing the helium with wax in the interfaces, the large massive housing is no longer required. Referring to Fig. 7 there is shown a further embodiment of the invention showing only a single chip 10 to be cooled with a spring loaded piston 26 urged against the back surface thereof. The piston 26 is the same as previously described, that is, with a central passage 32 filled with wax 33 and radial grooves 34 on the bottom surface thereof for enhancing the filling of the gap between the chip 10 and the bottom surface 25 of the piston 26 with the wax 33 during reflow. The piston 26 also contains the circumferential grooves 40 for preloading with wax 33 and the vertical channels 42 for enhancing the flow of the wax during the heating cycle to fill the gap between the piston 26 and the housing 50 with the wax. The housing 50 is shown as a light weight metallic element having essentially a raised or top-hat like portion 52 thereon which forms the housing wall of the annular interface 30. This housing 50 can be made of superplastic material such as zinc aluminium alloy. This light weight material can be molded into the desired shape and has good heat conductive qualities. The housing 50 having the top-hat extention 52 can be easily extended to a plurality of chip cooling arrangements by molding the housing 50 with a number of top-hat portions 52, one for each chip. The cooling can be provided by press fitting cooling fins 54 onto the top-hat portion 52 of the housing 50 to give sufficient surface area for blowing air to remove the heat. The fins 54 are constructed with a square peripheral configuration to maximize the available fin surface for convective heat transfer (see Fig. 9). The bottom of the housing 50 can be attached to the substrate 12 using a thermosetting silicone material to create a simple seal 56. The seal 56 is only necessary to keep the corrosive ambient atmosphere away from the chip. It does not have to contain a gas such as helium.

The high heat conductivity of materials such as wax and the ability of the material to fill the gaps during reflow heating and remain in the gap when solidified, thereby providing a low thermal resistance interface, have been utilized to provide a cooling unit for solid state electronic chips which must be kept within a specific thermal operating range. Also, various levels of coolability may be obtained by utilization of the proper combination of piston, housing materials and wax. The performance may be further enhanced through the use of thermally conductive filler materials mixed with the wax. Also, the wax in the annulus interface provides a highly viscous or semisolid piston to case connection, eliminating the potential for piston rebound under a shock and vibration environment.

**Claims**

1. A method of fabricating electrical apparatus comprising a heat generating electrical component (10) from which heat is conducted to a heat sink (60) by conduction from the component to a piston (26) slidably fitting in a cylinder bore (20) in a housing (16) and urged outwardly of the bore into heat conducting contact with the component, from the piston to the housing and from the housing to the heat sink, said method being characterised by the provision of an annular groove (40) around the peripheral surface of the piston together with a plurality of other grooves (42) leading from the annular groove lengthwise along that surface, by disposing a ring (35) of a solid heat conducting medium (33) having a low melting point between the piston and the wall of the bore in the annular groove around the piston, and heating the apparatus to melt the medium and cause it to be drawn along the other grooves and at least partially fill the gap (30) between the piston and the wall of the bore.

2. A method as claimed in claim 1, further characterised by the provision of a passage (32) extending lengthwise into the piston from an opening in the face (25) of the piston contacting the component and by the disposition in the passage of a quantity of the solid medium (33) such that during the heating the medium is introduced into gaps (28) between the contacting surfaces of the piston and the component.

3. A method as claimed in claim 2, further characterised by the provision of a passage (32) having a diameter great enough in conjunction with its length to provide sufficient medium to completely fill gaps between the contacting surfaces of the piston and the component.

4. A method as claimed in claim 2 or 3, further characterised by the provision of one or more radial grooves (34) in the component-contacting-surface (25) of the piston leading outwardly from the passage to draw the medium into gaps between the contacting surfaces of the piston and the component.

5. A method as claimed in claim 4, further characterised by the provision of radial grooves (34) of a cross-section such as to cause capillary flow of said material along said radial grooves in sufficient quantity to fill completely the gaps between the contacting surfaces of the piston and the component.

6. A method as claimed in any one of claims 1 to 5, further characterised by the provision of a component having a flat surface for heat conducting contact with an outwardly convex surface on the piston.

7. A method as claimed in any one of claims 1 to 6, further characterised by the provision of a number of annular grooves (40) spaced lengthwise along the piston and each initially containing a ring (35) of the solid medium (33), the number, placement and depth of the grooves being selected to each contain a large enough ring of the medium collectively to fill completely the gap between the peripheral surface of the piston and the wall of the bore during heating.

8. A method as claimed in any one of claims 1 to 7, further characterised by the use of wax or wax with a thermal conductive metal powder mixed therewith as the heat conductive medium.

**Revendications**

1. Procédé de fabrication d'un appareil électrique comprenant un composant électrique générateur de chaleur (10) à partir duquel la chaleur se propage vers un puits de chaleur, cette propagation se faisant à partir du composant vers un piston (26), coulissable dans un alésage cylindrique (20) aménagé dans un boîtier (16) et se dégageant de l'alésage pour venir faire contact avec le composant et lui communiquer la chaleur, du piston au boîtier et du boîtier au puits de chaleur, ledit procédé étant caractérisé par l'aménagement d'un sillon annulaire (40) sur la surface périphérique du piston ainsi que de plusieurs autres sillons (42) parcourant cette surface dans le sens de la longueur à partir du sillon annulaire, et par l'aménagement d'un anneau (35) fait dans un matériau solide conducteur de la chaleur (33) ayant un faible point de fusion et étant situé entre le piston et la paroi de l'alésage du sillon annulaire sur la périphérie du piston, et par le chauffage de l'appareil afin de faire fondre le matériau pour qu'il se propage dans les autres sillons et au moins partiellement dans l'entrefer (30) séparant le piston et la paroi de l'alésage.

2. Procédé selon la revendication 1, caractérisé en ce qu'il comprend en outre l'aménagement d'un passage (32) réalisé dans le sens de la longueur du piston à partir d'une ouverture dans la face (25) du piston faisant contact avec le composant, et par la présence dans le passage d'une quantité de matériau solide (33) de sorte que durant le chauffage le matériau s'introduise dans les entrefers (28) séparant les surfaces de contact du piston et le composant.

3. Procédé selon la revendication 2, caractérisé en outre en ce que le passage (32) a un diamètre suffisamment grand par rapport à sa longueur de sorte que le matériau puisse être en quantité suffisante pour remplir complètement les entrefers séparant les surfaces de contact du piston et le composant.

4. Procédé selon la revendication 2 ou la revendication 3, caractérisé en outre par l'aménagement de un ou de plusieurs sillons radiaux (34) dans la surface de contact 25 du piston avec le composant afin de permettre au matériau se trouvant dans le passage de s'engager dans les entrefers séparant les surfaces de contact du piston et le composant.

5. Procédé selon la revendication 4, caractérisé en outre par l'aménagement de sillons radiaux (34) dont la section transversale puisse permettre l'écoulement dudit matériau dans lesdits sillons radiaux suivant une quantité suffisante pour remplir complètement les entrefers séparant les surfaces de contact du piston et le composant.

6. Procédé selon l'une quelconque des revendications 1 à 5, caractérisé en outre en ce que le composant a une surface plane pour assurer la conduction de la chaleur par contact avec une surface externe convexe du piston.

7. Procédé selon l'une quelconque des revendications 1 à 6, caractérisé en outre par l'aménagement d'un certain nombre de sillons annulaires (40) séparés dans le sens de la longueur du piston et contenant chacun initialement un anneau (35) fait dans un matériau solide (33), le nombre, l'emplacement et la profondeur des sillons étant choisis de sorte qu'ils contiennent chacun un anneau suffisamment grand dudit matériau pour remplir, lors du chauffage, de façon collective et complètement l'entrefer séparant la surface périphérique du piston et la paroi de l'alésage.

8. Procédé selon l'une quelconque des revendications 1 à 7, caractérisé en outre par l'usage d'une cire ou d'une cire mélangée à une poudre de métal conducteur thermique comme matériau conducteur de la chaleur.

## Patentansprüche

1. Verfahren zur Herstellung von elektrischen Geräten, bestehend aus einem Wärme erzeugenden elektrischen Bauteil (10), von welchem Wärme zu einer Wärmesenke (60) durch Wärmeleitung vom elektrischen Bauteil (10) zu einem Kolben (26), von diesem zum Gehäuse und vom Gehäuse zu einer Wärmesenke geleitet wird, wobei der Kolben in einer Zylinderbohrung (20) in einem Gehäuse (16) gleitend angeordnet ist, und aus der Zylinderbohrung in Wärmekontakt mit dem elektrischen Bauteil gedrückt wird, gekennzeichnet durch die Herstellung einer ringförmigen Nut (40), um den Umfang des Kolbens und mehrerer anderer Nuten (42), die sich von der ringförmigen Nut in Längsrichtung entlang der Oberfläche erstrecken, durch Einbringen eines Ringes (35) eines festen wärmeleitenden Mediums (33) mit niedrigem Schmelzpunkt zwischen den Kolben und die Zylinderwandung in die ringförmige Nut um den Kolben, und durch Erwärmen des Gerätes, um das Medium zu schmelzen, damit es entlang der anderen Nuten verteilt wird, und die Lücken (30) zwischen dem Kolben und der Zylinderwandung wenigstens teilweise ausfüllt.

2. Verfahren nach Anspruch 1, gekennzeichnet durch die Herstellung eines Durchlasses (32), der sich in Längsrichtung des Kolbens von einer Öffnung in der Stirnseite (25) des Kolbens, die das Bauteil berührt, erstreckt, und durch das Einfügen einer Menge des festen Mediums (33), so daß während des Erwärmens das Medium in die Lücken (28) zwischen den sich berührenden Oberflächen des Kolbens und der elektrischen Bauteile gezogen wird.

3. Verfahren nach Anspruch 2, gekennzeichnet durch die Herstellung eines Durchlasses (32), dessen Durchmesser in Verbindung mit seiner Länge groß genug ist, um genügend Medium aufzunehmen, um alle Lücken zwischen den sich berührenden Oberflächen von Kolben und Bauteil auszufüllen.

4. Verfahren nach Anspruch 2 oder 3, gekennzeichnet durch die Herstellung von einer oder mehreren radialen Nuten (34) in der das elektrische Bauteil berührenden Oberfläche (25) des Kolbens, die vom Durchlaß sich auswärts erstrecken, um das Medium in Lücken zwischen den sich berührenden Oberflächen des Kolbens und des Bauteils zu ziehen.

5. Verfahren nach Anspruch 4, gekennzeichnet durch die Herstellung der radialen Nuten (34) mit einem solchen Querschnitt, daß sie einen Kapillarfluß des Mediums entlang der radialen Nuten in ausreichender Menge bewirken, um die Lücken zwischen den sich berührenden Oberflächen des Kolbens und des Bauteiles zu füllen.

6. Verfahren nach einem der Ansprüche 1 bis 5, gekennzeichnet durch die Verwendung eines Bauteils mit flacher Oberfläche in wärmeleitender Berührung mit einer konvexen Oberfläche des Kolbens.

7. Verfahren nach einem der Ansprüche 1 bis 6, gekennzeichnet durch die Herstellung mehrerer ringförmiger Nuten (40) entlang der Länge des Kolbens, von denen jeder anfangs einen Ring (35) des festen Mediums (33) enthält, wobei die Anordnung und Tiefe der Nuten so gewählt sind, daß jeder einen Ring des Mediums enthält, die zusammen so groß sind, daß sie ausreichen, um die Lücken zwischen der Oberfläche des Kolbens und der Zylinderwandung während der Erwärmung auszufüllen.

8. Verfahren nach einem der Ansprüche 1 bis 7, gekennzeichnet durch die Verwendung von Wachs oder Wachs mit einem wärmeleitenden Metallpulver als wärmeleitendes Medium.

# FIG. 2

# FIG. 1

# FIG. 3

# FIG. 9

FIG. 5     FIG. 4     FIG. 6

FIG. 7

FIG. 8

MAXIMUM ALLOWABLE CHIP POWER ~ WATTS

MODULE POWER ~ WATTS